(19) Europäisches Patentamt / European Patent Office / Office européen des brevets

(11) **EP 3 371 265 B1**

(12) **EUROPEAN PATENT SPECIFICATION**

(45) Date of publication and mention
of the grant of the patent:
**19.08.2020 Bulletin 2020/34**

(51) Int Cl.:
***C09D 123/08*** *(2006.01)*     ***C08K 5/00*** *(2006.01)*
***C09D 151/06*** *(2006.01)*     ***C08K 5/541*** *(2006.01)*
***H01L 31/048*** *(2014.01)*

(21) Application number: **16782237.8**

(22) Date of filing: **18.10.2016**

(86) International application number:
**PCT/EP2016/074926**

(87) International publication number:
**WO 2017/076629 (11.05.2017 Gazette 2017/19)**

(54) **A PHOTOVOLTAIC MODULE**

PHOTOVOLTAIKMODUL

MODULE PHOTOVOLTAÏQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.11.2015 EP 15192984**

(43) Date of publication of application:
**12.09.2018 Bulletin 2018/37**

(73) Proprietor: **Borealis AG
1220 Vienna (AT)**

(72) Inventors:
• **ODERKERK, Jeroen
44452 Stenungsund (SE)**
• **COSTA, Francis
4040 Linz (AT)**

• **BROEDERS, Bert
3580 Beringen (BE)**
• **GALGALI, Girish Suresh
4021 Linz (AT)**
• **HELLSTRÖM, Stefan
442 42 Kungälv (SE)**

(74) Representative: **Maiwald Patent- und
Rechtsanwaltsgesellschaft mbH
Elisenhof
Elisenstraße 3
80335 München (DE)**

(56) References cited:
**EP-A1- 2 144 301     EP-A1- 2 579 331
EP-A1- 2 892 080**

EP 3 371 265 B1

**Description**

The present invention relates to a photovoltaic (PV) module and to a lamination process for producing said PV module.

**Background**

The photovoltaic modules, also known as solar cell modules, are well known in the solar energy technology. Photovoltaic (PV) modules produce electricity from light and are used in various kind of applications as well known in the field. The type of the photovoltaic module can vary. The modules have typically a multilayer structure, i.e. several different layer elements wich have different functions. The layer elements of the photovoltaic module can vary with respect to layer materials and layer structure. The final photovoltaic module can be rigid or flexible.

The rigid photovoltaic module can for example contain a protective front layer element, which can be non-rigid, e.g. polymeric layer element, or rigid, e.g. a glass layer element, front encapsulation layer element, a photovoltaic element, rear encapsulation layer element and a protective back layer element (also known e.g. backsheet element), which can be e.g. a flexible polymeric layer element or a rigid, like a glass layer element. The PV module can be arranged e.g. to an aluminium frame.

In flexible modules the top layer element can be e.g. a fluorinated layer made from polyvinylfluoride (PVF) or polyvinylidenefluoride (PVDF) polymer. The encapsulation layer(s) is typically made from ethylene vinyl acetate (EVA). Also the backsheet element is then flexible, like a polymeric mono- or multilayer element.

The above exemplified layer elements can be monolayer or multilayer elements. Moreover, there may be adhesive layer(s) between the layers of an element or between the different layer elements.

All said terms have a well known meaning in the art.

As to rigid PV modules, typically one or both of the protective front or back layer elements is rigid, like a glass layer. For instance, due to "poor" heat transfer properties of glass, the glass-glass PV modules (also known e.g. as dual glass PV modules) require very long lamination time and also an increased temperature for the lamination process. On the other hand to ensure proper surface wetting and less stress on the solar cells of the photovoltaic layer element during solar module lamination, polymers with high melt flow rate (MFR) are usually used as encapsulant layer element, also in dual glass PV modules. Additionally, for instance EVA to be suitable e.g. as PV encapsulant material must usually have high VA content to get feasible flowability/processability behaviour. The conventional EVA with high VA content has then also very high $MFR_2$ (more than 15 g/10 min). However, when such encapsulant layer element is based on high MFR thermoplastic material, there exists a big risk of substantial flow (flash) out of the encapsulation material during module lamination due to there high high flowability. In addition to the problem of flowing-out of encapsulant material, there is also a risk of shifting (undesired movement) of the solar cells. Therefore EVA and other thermoplasts with high MFR need usually be crosslinked simultaneously during the application of pressure, typically by peroxide. The flowing-out problem can be overcome with encapsulant element material which is crosslinked (and crosslinks very fast) during lamination. The lamination temperature must then be high enough to decompose the peroxide to initiate the crosslinking reaction. Also the lamination time must be prolonged to complete the crosslinking. After lamination, the cooling time must also be long enough to remove the undesired by-products of the crosslinking reaction.

The crosslinking of the encapsulant material brings also limitations to the encapsulant (film) extrusion process. For instance if EVA is crosslinked, then peroxide, which is usually used as the crosslinking agent, is added to the EVA composition before the extrusion of the layer element (e.g. the encapsulation layer elements), whereby even partial crosslink reaction during the layer extrusion can reduce MFR resulting in non-processable film. Accordingly, the film extrusion process brings restriction to the use of starting material containing EVA with low MFR and peroxide, although low MFR material would in general be desirable to use in a film extrusion process. As a result the film extrusion process cannot be carried out in optimal conditions.

Additionally, the semicondutors or the solar cell wafers present in the PV module are fragile and cannot withstand high mechanical stresses during the lamination process of the PV module. Therefore materials having low shear thinning behaviour typically have also high viscosity (poor flowability in molten stage) during the lamination process and excert mechanical stress to said fragile parts of the PV module causing undesirable ruptures to the PV module which impair the proper functioning and life time of the PV module. State of the art encapsulation layers have been disclosed in EP-A-2892080, EP-A-2144301 and EP-A-2579331.

All the above problems bring thus complexity to the PV module production process and increase the lamination cycle, which increase the production costs.

There is a continuous need for polymeric materials for layers of rigid PV modules which overcome the above problems.

**Figures**

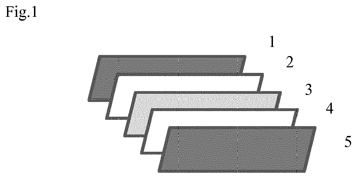

Figure 1 illustrates the layer elements (separated) of the preferable embodiment of the invention, namely a protective front layer element (1), a front encapsulation layer element (2), a photovoltaic element (3), a rear encapsulation layer element (4) and a protective back layer element (5) a photovoltaic module laminate.

**Description of the invention**

The present invention provides a photovoltaic module comprising, in the given order, a rigid protective front layer element, a front encapsulation layer element, a photovoltaic element, a rear encapsulation layer element and a rigid protective back layer element, wherein at least one of the front encapsulation layer element or rear encapsulation element comprises a polymer composition comprising

- a polymer of ethylene (a) selected from:

  (a2) a polymer of ethylene containing one or more polar comonomer(s) selected from (C1-C6)-alkyl acrylate comonomer(s), and optionally bears functional group(s) containing units other than said polar comonomer; or
  (a3) a polymer of ethylene containing one or more alpha-olefin comonomer selected from (C1-C10)-alpha-olefin comonomer; and optionally bears functional group(s) containing units, whereby the comonomer(s) of polymer (a) are other than vinyl acetate; and

- silane group(s) containing units (b);
  and wherein the polymer composition has a melt flow rate, $MFR_2$, of less than 20 g/10 min (according to ISO 1133 at 190 °C and at a load of 2.16 kg) and wherein the polymer composition is not subjected to any silanol condensation catalyst (SCC). which is selected from the group of carboxvlates of tin, zinc, iron, lead or cobalt or aromatic organic sulphonic acids, before or during the production process of the photovoltaic module.

The polymer composition of the invention as defined above, below or in claims is referred herein also shortly as "polymer composition" or "composition".

The expression "polymer of ethylene (a) selected from:

  (a2) a polymer of ethylene containing one or more polar comonomer(s) selected from (C1-C6)-alkyl acrylate comonomer(s), and optionally bears functional group(s) containing units other than said polar comonomer; or
  (a3) a polymer of ethylene containing one or more alpha-olefin comonomer selected from (C1-C10)-alpha-olefin comonomer; and optionally bears functional group(s) containing units;"

as defined above, below or in claims is referred herein also shortly as "polymer (a)".

"Rigid" means herein that the element is stiff and can not be bended in a manner as flexible elements, and if bended, then typically the integrity of the element typically breaks easily causing permanet fractures, as is not the case with flexible element. A skilled person can easily differentiate a rigid and flexible layer element.

Unexpectedly, the flowing-out of the polymer of the invention during lamination process is decreased or minimal without the need to crosslink the polymer with a conventional crosslinking agent before or during the lamination process.

Further unexpectedly, the composition of the invention comprising the combination of the polymer (a) and the silane group(s) containing units (b) makes it possible to use, if desired, a polymer of ethylene (a) with decreased melt flow rate (MFR) over the prior art for producing, e.g. by extrusion, for instance a front and/or rear encapsulation layer element for a rigid PV module.

Furthermore, the possibility of having a decreased MFR of polymer (a) over the prior art, if desired, offers even higher resistance to flow under pressing step or during cooling/recovering step in a lamination process of the PV module.

Furthermore, the possibility to use a decreased MFR of polymer (a) over the prior art, if desired, further contributes to use optimum film extrusion conditions for producing the front and/or brear encapsulation layer element, to increase the out-put of the film production and to obtain film with good quality.

Moreover, the option to use a decreased MFR of the polymer (a) over the prior art has further benefits during lamination process of the PV module, like less movement of the a photovoltaic element during assembling step of the different layer elements of the PV module, prevents floating and movement of the rigid front encapsulation layer element, like glass layer, on the molten encapsulant layer element during module lamination process and/or helps to keep the alignment of the photovoltaic element intact in the final PV module.

Furthermore, the composition of the invention has surprisingly high shear thinning behaviour enabling easy melt processibility of the composition even at low shear. Moreover, the polyethylene composition of the invention has a balance of high shear thinning at lower shear manifested during lamination process. The composition of the invention having the desirable low viscosity (more flowabile in molten stage) during lamination exerts less stress on the solar cell.

Further unexpectedly, the encapsulation layer element, comprising the composition of the invention comprising the combination of the polymer (a) and the silane group(s) containing units (b), when in contact with a glass layer as the rigid protective front or back layer element, enables to keep better integrity of the glass layer when subjected to a mechanical force compared to prior art encapsulation layer materials. This can be demonstrated with an impact test, whereby the glass layer is shattered into smaller pieces, i.e. no sharp, loose and big chuncks of glass are formed.

The invention further provides a photovoltaic module as defined in claim 1 comprising, in the given order, a rigid protective front layer element, a front encapsulation layer element, a photovoltaic element, a rear encapsulation layer element and a rigid protective back layer element, wherein at least one layer element, preferably at least one of the front encapsulation layer element or rear encapsulation element, comprises a polymer composition comprising:
(a2) a polymer of ethylene containing one or more polar comonomer(s) selected from (C1-C6)-alkyl acrylate comonomer(s) and optionally bears functional group(s) containing units other than said polar comonomer; and

- (b) silane group(s) containing units;
- wherein the polymer of ethylene (a) has a melting temperature, Tm, of 100 °C or less,
- wherein the polymer of ethylene (a) has a melt flow rate, $MFR_2$, of less than 20 g/10 min (according to ISO 1133 at 190 °C and at a load of 2.16 kg); and preferably
- wherein no silane condensation catalyst (SCC), which is selected from the SCC group of carboxylates of tin, zinc, iron, lead or cobalt or aromatic organic sulphonic acids, is present in the polymer of ethylene (a) of the polymer composition.

The invention further provides a lamination as defined in the claims for producing a photovoltaic module comprising, in the given order, a rigid protective front layer element, a front encapsulation layer element, a photovoltaic element, a rear encapsulation layer element and a rigid protective back layer element, wherein at least one of the front encapsulation layer element and rear encapsulation element comprises a polymer composition comprising

- a polymer of ethylene (a) selected from:

    (a2) a polymer of ethylene containing one or more polar comonomer(s) selected from (C1-C6)-alkyl acrylate comonomer(s) and optionally bears functional group(s) containing units other than said polar comonomer; or
    (a3) a polymer of ethylene containing one or more alpha-olefin comonomer selected from (C1-C10)-alpha-olefin comonomer; and optionally bears functional group(s) containing units; and

- silane group(s) containing units (b);
  and wherein the polymer (a) has a melt flow rate, $MFR_2$, of less than 20 g/10 min (according to ISO 1133 at 190 °C and at a load of 2.16 kg);
  wherein the process comprises the steps of:

    (i) assembling step to arrange the rigid protective front layer element, the front encapsulation layer element, the photovoltaic element, the rear encapsulation layer element and the rigid protective back layer element, in given order, to form of a photovoltaic module assembly;
    (ii) heating step to heat up the photovoltaic module assembly optionally in a chamber at evacuating conditions;
    (iii) pressing step to build and keep pressure on the photovoltaic module assembly at the heated conditions for the lamination of the assembly to occur; and
    (iv) recovering step to cool and remove the obtained photovoltaic module for later use.

The following preferable embodiments, properties and subgroups of the photovoltaic module of the invention, polyethylene composition, the polymer (a), silane group(s) containing units (b) thereof as well as the lamination process of the PV module of the invention, are independently generalisable so that they can be used in any order or combination to further define the suitable embodiments of the invention.

**Polymer (a), silane group(s) containing units (b) and the polymer composition**

The polymer composition of the front and/or rear enpsulation layer element comprises

- a polymer of ethylene (a) selected from:

(a2) a polymer of ethylene containing one or more polar comonomer(s) selected from (C1-C6)-alkyl acrylate comonomer(s) and optionally bears functional group(s) containing units other than said polar comonomer; or
(a3) a polymer of ethylene containing one or more alpha-olefin comonomer selected from (C1-C10)-alpha-olefin comonomer; and optionally bears functional group(s) containing units; and
- silane group(s) containing units (b).

Accordingly, silane group(s) containing units (b) are always combined with polymer (a) and with the preferable embodiments thereof.

It is preferred that the polymer composition of the front and/or rear enpsulation layer element comprises, preferably consists of,

- a polymer of ethylene (a) as defined above below or in claims;
- silane group(s) containing units (b) as defined above below or in claims; and
- additive(s) and optionally filler(s), preferably additive(s), as defined below.

Further preferably the front and/or rear enpsulation monolayer element or at least one layer of the front and/or rear enpsulation multilayer element consists of the polymer composition of the invention.

As well known "comonomer" refers to copolymerisable comonomer units.

The comonomer(s) of polymer (a), if present, is/are other than vinyl acetate comonomer. The polymer composition is without (does not comprise) a copolymer of ethylene with vinyl acetate comonomer.

Preferably, the comonomer(s) of polymer (a), if present, is/are other than glycidyl methacrylate comonomer. Preferably, the polymer composition is without (does not comprise) a copolymer of ethylene with acrylate and glycidyl methacrylate comonomers.

The content of optional comonomer(s), if present in polymer (a1), polar commoner(s) of polymer (a2) or alpha-olefin comonomer(s) of polymer (a3), is preferably of 4.5 to 18 mol%, preferably of 5.0 to 18.0 mol%, preferably of 6.0 to 18.0 mol%, preferably of 6.0 to 16.5 mol%, more preferably of 6.8 to 15.0 mol%, more preferably of 7.0 to 13.5 mol%, when measured according to "Comonomer contents" as described below under the "Determination method".

The silane group(s) containing units (b) and the polymer (a) can be present as a separate components, i.e. as blend (composition), in the polymer composition of the invention, or the silane group(s) containing units (b) can be present as a comonomer of the polymer (a) or as a compound grafted chemically to the polymer (a). In general, copolymerisation and grafting of the silane group(s) containing units to ethylene are well known techniques and well documented in the polymer field and within the skills of a skilled person.

In case of a blend, the silane group(s) containing units (b) component (compound) may, at least partly, be reacted chemically with the polymer (a), e.g. grafted to polymer (a), using optionally e.g. a radical forming agent, such as peroxide. Such chemical reaction may take place before or during the lamination process of the the invention.

Preferably the silane group(s) containing units (b) are present (bonded) in the polymer (a). More preferably, the polymer (a) bears functional group(s) containing units, whereby said functional group(s) containing units are said silane group(s) containing units (b). In this embodiment the silane group(s) containing units (b) can be copolymerised or grafted to the polymer (a). Accordingly, the silane group(s) containing units (b) as the preferable functional group(s) containing units are preferably present in said polymer (a) in form of comonomer units or in form of grafted compound.

In more preferable embodiment of the invention, the polymer (a) comprises functional group(s) containing units which are the silane group(s) containing units (b) as comonomer in the polymer (a). The copolymerisation provides more uniform incorporation of the units (b). Moreover, the copolymerisation does not require the use of peroxide which is typically needed for the grafting of said units to polyethylene. It is known that peroxide brings limitations to the choice of MFR of the polymer used as a starting polymer (during grafting the MFR of the polymer decreases) for a PV module and the by-products formed from peroxide can deteriorate the quality of the polymer.

The polymer composition more preferably comprises

- polymer (a) which is selected from
(a2) a polymer of ethylene containing one or more polar comonomer(s) selected from (C1-C6)-alkyl comonomer(s) and optionally bears functional group(s) containing units other than said polar comonomer; and
- silane group(s) containing units (b).

Furthermore, the comonomer(s) of polymer (a) is/are preferably other than the alpha-olefin comonomer as defined above.

In one equally preferable embodiment A2, the polymer composition comprises

- a polymer (a) which is the polymer of ethylene (a2) containing one or more polar comonomer(s) selected from (C1-C6)-alkyl acrylate and bears functional group(s) containing units other than said polar comonomer; and
- silane group(s) containing units (b): more preferably
  the polymer composition comprises a polymer (a) which is the polymer of ethylene (a2) containing one or more polar and bears the silane group(s) containing units (b) as the functional group(s) containing units (also referred as "polymer (a2) with the polar comonomer and the silane group(s) containing units (b)" or "polymer (a2)").

The "polymer (a1) or polymer (a2)" is also referred herein as "polymer (a1) or (a2)".

The content of the polar comonomer present in the polymer (a2) is preferably of 4.5 to 18 mol%, preferably of 5.0 to 18.0 mol%, preferably of 6.0 to 18.0 mol%, preferably of 6.0 to 16.5 mol%, more preferably of 6.8 to 15.0 mol%, more preferably of 7.0 to 13.5 mol%, when measured according to "Comonomer contents" as described below under the "Determination methods". The polymer (a2) with the polar comonomer and the silane group(s) containing units (b) contains preferably one polar comonomer as defined above, below or in claims. In a preferable embodiment of A1, said polar comonomer(s) of copolymer of ethylene (a2) is a polar comonomer selected from (C1-C4)-alkyl acrylate or (C1-C4)-alkyl methacrylate comonomer(s) or mixtures thereof. More preferably, said polymer (a2) contains one polar comonomer which is preferably (C1-C4)-alkyl acrylate comonomer.

The most preferred polar comonomer of polymer (a2) is methyl acrylate. The methyl acrylate has very beneficial properties such as excellent wettability, adhesion and optical (e.g. transmittance) properties, which contribute to the quality of the obtained PVmodule and e.g. to the lamination process thereof. Moreover, the thermostability properties of methyl acrylate (MA) comonomer are also highly advantageous. For instance, methyl acrylate is the only acrylate which cannot go through the ester pyrolysis reaction, since does not have this reaction path. As a result, if the polymer (a2) with MA comonomer degrades at high temperatures, then there is no harmful acid (acrylic acid) formation which improves the quality and life cycle of the PV module. This is not the case e.g. with vinyl acetate of EVA or with other acrylates like ethyle acrylate (EA) or butyl acrylate (BA) which, on the contrary, can go through the ester pyrolysis reaction, and if degrade, would form the harmful acid and for the acrylates also volatile olefinic by-products.

The melt flow rate, $MFR_2$, of the polymer (a), preferably of the polymer (a2), is preferably of less than 15, preferably from 0.1 to 15, preferably from 0.2 to 13, preferably from 0.3 to 13, more preferably from 0.4 to 13, g/10 min (according to ISO 1133 at 190 °C and at a load of 2.16 kg).

The polymer composition comprising the polymer (a) and the silane group(s) containing units (b), more preferably the polymer (a2) thus enables to decrease the MFR of the polymer (a), preferably polymer (a1) or (a2), compared to prior art and thus offers higher resistance to flow under pressing step (iii) and/or (iv) recovering step. As a result, the preferable MFR can further contribute, if desired, to the quality of the final PV module of the invention, and to the short production, e.g. by lamination, cycle time of the PV module.

The polymer composition comprising the polymer (a) and the silane group(s) containing units (b), more preferably the polymer (a2), present in the polymeric layer has preferably a Shear thinning index, $SHI_{0.05/300}$, of 30.0 to 100.0, preferably of of 40.0 to 80.0, when measured according to "Rheological properties: Dynamic Shear Measurements (frequency sweep measurements)" as described below under "Determination Methods".

The preferable SHI range further contributes to the quality of the final PV module and to the short production, e.g. by lamination, cycle time. The preferale SHI also further reduces the stress on the PV cell element.

Furthermore, the preferable combination of the preferable SHI and the preferable low MFR of the polymer composition, preferably of the polymer (a), more preferably the polymer (a2), further contributes to a desirable high zero shear rate viscosity of the polymer composition, thereby further contributes to the reduction or prevention of the flow out of the material during the production process, e.g. by lamination, of the PV module. And in this preferable embodiment the melt of said polymer (a), more preferably the polymer (a2), further contributes to a proper wetting of various interfaces (layer elements) within the PV module. Accordingly, the combination of the preferable SHI and the preferable MFR range of the polymer composition, preferably of the polymer (a), more preferably the polymer (a2), further contributes to the quality of the final PV module and to the short production, e.g. by lamination, cycle time.

As already mentioned, with the present preferable polymer composition the crosslinking of the polymer (a), preferably of the polymer (a1) or (a2), can be avoided, if desired, which contributes to achieve the good quality of the final PV module and, additionally, to shorten the production, e.g. by lamination, cycle time without deteriorating the quality of the formed multilayer laminate. For instance, the recovering step of the preparation process of PV module can be short, since time consuming removal of by-products, which are typically formed in the prior art peroxide crosslinking, is not needed.

The polymer (a), preferably of the polymer (a1) or (a2), has preferably a Melt Temperature, Tm, of 70°C or more, preferably 75°C or more, more preferably 78°C or more, when measured as described below under "Determination Methods". Preferably the upper limit of the Melt Temperature is 100°C or below, preferably 95°C or below.

Typically, and preferably the density of the polymer of ethylene (a), preferably of the polymer (a1) or (a2), is higher than 860 kg/m$^3$. Preferably the density is not higher than 970 kg/m$^3$, and preferably is from 920 to 960 kg/m$^3$,

according to ISO 1872-2 as described below under "Determination Methods".

The silane group(s) containing comonomer unit or compound as the silane group(s) containing units (b) is suitably a hydrolysable unsaturated silane compound represented by the formula R1SiR2qY3-q (I) wherein

R1 is an ethylenically unsaturated hydrocarbyl, hydrocarbyloxy or (meth)acryloxy hydrocarbyl group,

each R2 is independently an aliphatic saturated hydrocarbyl group,

Y which may be the same or different, is a hydrolysable organic group and

q is 0, 1 or 2.

Special examples of the unsaturated silane compound are those wherein R1 is vinyl, allyl, isopropenyl, butenyl, cyclohexanyl or gamma-(meth)acryloxy propyl; Y is methoxy, ethoxy, formyloxy, acetoxy, propionyloxy or an alkyl- or arylamino group; and R2, if present, is a methyl, ethyl, propyl, decyl or phenyl group.

Further suitable silane compounds or, preferably, comonomers are e.g. gamma-(meth)acryl-oxypropyl trimethoxysilane, gamma(meth)acryloxypropyl triethoxysilane, and vinyl triacetoxysilane, or combinations of two or more thereof.

As a suitable subgroup of unit of formula (I) is an unsaturated silane compound or, preferably, comonomer of formula (II)

$$CH2=CHSi(OA)3 \qquad (II)$$

wherein each A is independently a hydrocarbyl group having 1-8 carbon atoms, suitably 1-4 carbon atoms.

In one embodiment of silane group(s) containing units (b) of the invention, comonomers/compounds of formula (I), preferably of formula (II), are vinyl trimethoxysilane, vinyl bismethoxyethoxysilane, vinyl triethoxysilane, vinyl trimethoxysilane.

The amount of the silane group(s) containing units (b) present in the polymeric layer element, preferably in the polymer (a), is from 0.01 to 1.00 mol%, suitably from 0.05 to 0.80 mol%, suitably from 0.10 to 0.60 mol%, suitably from 0.10 to 0.50 mol%, when determined according to "Comonomer contents" as described below under "Determination Methods".

As already mentioned the silane group(s) containing units (b) are present in the polymer (a), more preferably in the polymer (a1) or (a2), as a comonomer. embodiment A2, the polymer (a2) is a copolymer of ethylene with a (C1-C4)-alkyl acrylate comonomer and silane group(s) containing units (b) according to formula (I) as comonomer, more preferably and silane group(s) containing units (b) according to formula (II) as comonomer, more preferably and silane group(s) containing units (b) according to formula (II) selected from vinyl trimethoxysilane, vinyl bismethoxyethoxysilane, vinyl triethoxysilane or vinyl trimethoxysilane comonomer, as defined above or in claims. Most preferably in this embodiment A2 the polymer (a2) is a copolymer of ethylene with methyl acrylate comonomer and with vinyl trimethoxysilane, vinyl bismethoxyethoxysilane, vinyl triethoxysilane or vinyl trimethoxysilane comonomer, preferably with vinyl trimethoxysilane comonomer.

As said, the polymer composition of at least one of the front or rear encapsulation layer element is not subjected to any silanol condensation catalyst (SCC), which is selected from the group of carboxylates of tin, zinc, iron, lead or cobalt or aromatic organic sulphonic acids, before or during the production process of the PV module of the invention.

Preferably, the polymer composition of at least one of the front or rear encapsulation layer element is not subjected to any peroxide, before or during the production process of the PV module of the invention.

The polymer composition which is crosslinked for instance using the above crosslinking agents has a typical network, i.a. interpolymer crosslinks (bridges), as well known in the field. The crosslinking degree may vary depending on the end application.

No silane condensation catalyst (SCC) which is selected from the SCC group of tin-organic catalysts or aromatic organic sulphonic acids is subjected to the polymer composition of said at least one of front or rear encapsulation layer element before or during the production process, e.g. by lamination, of the PV module of the invention.

The silanol condensation catalyst (SCC), which is not used for crosslinking the polymer composition of at least one of the front or rear encapsulation layer element before or during the production process, e.g. by lamination, is more preferably selected from the group C of carboxylates of metals, such as tin, zinc, iron, lead and cobalt; from a titanium compound bearing a group hydrolysable to a Brönsted acid (preferably as described in WO 2011160964 of Borealis, included herein as reference), from organic bases; from inorganic acids; and from organic acids; suitably from carboxylates of metals, such as tin, zinc, iron, lead and cobalt, from titanium compound bearing a group hydrolysable to a Brönsted acid as defined above or from organic acids, suitably from dibutyl tin dilaurate (DBTL), dioctyl tin dilaurate (DOTL), particularly DOTL; titanium compound bearing a group hydrolysable to a Brönsted acid as defined above; or an aromatic organic sulphonic acid, which is suitably an organic sulphonic acid which comprises the structural element:

$$Ar(SO3H)x \qquad (II)$$

wherein Ar is an aryl group which may be substituted or non- substituted, and if substituted, then suitably with at least one hydrocarbyl group up to 50 carbon atoms, and x is at least 1; or a precursor of the sulphonic acid of formula (II) including an acid anhydride thereof or a sulphonic acid of SE1518

formula (II) that has been provided with a hydrolysable protective group(s), e.g. an acetyl group that is removable by hydrolysis. Such organic sulphonic acids are described e.g. in EP736065, or alternatively, in EP1309631 and EP1309632.

The polymer (a) of the polymeric layer is not crosslinked before introducing to the lamination process or during the lamination process using silanol condensation catalyst (SCC), which is selected from the group of carboxylates of tin, zinc, iron, lead or cobalt or aromatic organic sulphonic acids, preferably from the above preferable SCC according to group C, or preferably using peroxide or electronic beam irradiation.

Also the layer element(s), which is/are in direct contact with the front and/or rear encapsulation layer(s) comprising the polymer composition of the invention, are without a crosslinking agent selected from silanol condensation catalyst (SCC), which is selected from the group of carboxylates of tin, zinc, iron, lead or cobalt or aromatic organic sulphonic acids, preferably from the above preferable SCC according to group C. or preferably peroxide.

It is preferred that the polymer composition of at least one of the front or rear encapsulation layer element is not crosslinked with the crosslinking agent, as defined above, before introducing to or during the production process of the PV module, e.g. by lamination, or before or during the use of the PV module in the end application.

Accordingly, in one embodiment the polymer composition of the invention suitably comprises additives other than fillers (like flame retardants (FRs)). Then the polymer composition comprises, preferably consists of, based on the total amount (100 wt%) of the polymer composition,

- 90 to 99.9999 wt% of the polymer (a)
- 0.01 to 1.00 mol% silane group(s) containing units (b) and
- suitably 0.0001 to 10 wt% of the additives.

The total amount of optional additives is suitably between 0.0001 and 5.0 wt%, like 0.0001 and 2.5 wt%.

The optional additives are e.g. conventional additives suitable for the desired end application and within the skills of a skilled person, including without limiting to, preferably at least antioxidant(s) and UV light stabilizer(s), and may also include metal deactivator(s), nucleating agent(s), clarifier(s), brightener(s), acid scavenger(s), as well as slip agent(s) or talc etc. Each additive can be used e.g. in conventional amounts, the total amount of additives present in the polymer composition SE1518 being preferably as defined above. Such additives are generally commercially available and are described, for example, in "Plastic Additives Handbook", 5th edition, 2001 of Hans Zweifel.

In another embodiment the polymer composition of the invention comprises in addition to the suitable additives as defined above also fillers, such as pigments, FRs with flame retarding amounts or carbon black. Then the polymer composition of the invention comprises, preferably consists of, based on the total amount (100wt%) of the polymeric layer element,

- 30 to 90 wt%, suitably 40 to 70 wt%, of the polymer (a)
- 0.01 to 1.00 mol% silane group(s) containing units (b) and
- up to 70 wt%, suitably 30 to 60 wt%, of the filler(s) and the suitable additives.

As non-limiting examples, the optional filler(s) comprise Flame Retardants, such as magensiumhydroxide, ammounium polyphosphate etc.

In the preferred embodiment the polymer composition comprises, preferably consists of,

- 90 to 99.9999 wt% of the polymer (a)
- 0.01 to 1.00 mol% silane group(s) containing units (b) and
- 0.0001 to 10 wt% additives and optionally fillers, preferably 0.0001 to 10 wt% additives.

In a preferable embodiment the polymer composition consists of the polymer (a) as the only polymeric component(s). "Polymeric component(s)" exclude herein any carrier polymer(s) of optional additive or filler product(s), e.g. master batch(es) of additive(s) or, respectively, filler(s) together with the carrier polymer, optionally present in the polymer composition of the polymeric layer. Such optional carrier polymer(s) are calculated to the amount of the respective additive or, respectively, filler based on the amount (100 %) of the polymer composition.

The polymer (a) of the polymer composition can be e.g. commercially available or can be prepared according to or analogously to known polymerization processes described in the chemical literature.

In a preferable embodiment the polymer (a), preferably the polymer (a2), is produced by polymerising ethylene suitably with silane group(s) containing comonomer (= silane group(s) containing units (b)) as defined above and optionally with one or more other comonomer(s) in a high pressure (HP) process using free radical polymerization in the presence of one or more initiator(s) and optionally using a chain transfer agent (CTA) to control the MFR of the polymer. The HP reactor can be e.g. a well known tubular or autoclave reactor or a mixture thereof, suitably a tubular reactor. The high pressure (HP) polymerisation and the adjustment of process conditions for further tailoring the other properties of the polymer depending on the desired end application are well known and described in the literature, and can readily be used by a skilled person. Suitable polymerisation temperatures range up to 400 °C, suitably from 80 to 350°C and pressure from 70 MPa, suitably 100 to 400 MPa, suitably from 100 to 350 MPa. The high pressure polymerization is generally performed at pressures of 100 to 400 MPa and at temperatures of 80 to 350 °C. Such processes are well known and well documented in the literature and will be further described later below.

The incorporation of the comonomer(s), if present, and optionally, and preferably, the silane group(s) containing units (b) suitably as comonomer as well as comonomer(s) and the control of the comonomer feed to obtain the desired final content of said comonomers and of optional, and preferable, silane group(s) containing units (b) as the comonomer can be carried out in a well known manner and is within the skills of a skilled person.

Further details of the production of ethylene (co)polymers by high pressure radical polymerization can be found i.a. in the Encyclopedia of Polymer Science and Engineering, Vol. 6 (1986), pp 383-410 and Encyclopedia of Materials: Science and Technology, 2001 Elsevier Science Ltd.: "Polyethylene: High-pressure, R.Klimesch, D.Littmann and F.-O. Mähling pp. 7181-7184.

Such HP polymerisation results in a so called low density polymer of ethylene (LDPE), herein with the optional (polar) comonomer as defined above or in claims and with optional, and preferable silane group(s) containing comonomer as the silane group(s) containing units (b). The term LDPE has a well known meaning in the polymer field and describes the nature of polyethylene produced in HP, i.e the typical features, such as different branching architecture, to distinguish the LDPE from PE produced in the presence of an olefin polymerisation catalyst (also known as a coordination catalyst). Although the term LDPE is an abbreviation for low density polyethylene, the term is understood not to limit the density range, but covers the LDPE-like HP polyethylenes with low, medium and higher densities.

**PV module**

The invention thus provides a photovoltaic module comprising, in the given order, a rigid protective front layer element, a front encapsulation layer element, a photovoltaic element, a rear encapsulation layer element and a rigid protective back layer element, wherein at least one of the front encapsulation layer element or rear encapsulation element comprises a polymer composition comprising

- a polymer of ethylene (a) selected from:

> (a2) a polymer of ethylene containing one or more polar comonomer(s) selected from (C1-C6)-alkyl acrylate comonomer(s) and optionally bears functional group(s) containing units other than said polar comonomer; or
> (a3) a polymer of ethylene containing one or more alpha-olefin comonomer selected from (C1-C10)-alpha-olefin comonomer; and optionally bears functional group(s) containing units; and

- silane group(s) containing units (b);
  and wherein the polymer (a) has a melt flow rate, $MFR_2$, of less than 20 g/10 min (according to ISO 1133 at 190 °C and at a load of 2.16 kg).

Preferably both the front and rear encapsulation layer element comprises the polymer composition of the invention as defined above or in claims including the preferable subgroups and embodiments thereof, in any order. The polymer composition of the invention of the front encapsulation layer element and of rear encapsulation layer element can be same or different, preferably same.

The front encapsulation layer element and/or rear encapsulation layer element can be independently a monolayer element or a multilayer element. Preferably the front and/or rear enpsulation monolayer element or at least one layer of the front and/or rear enpsulation multilayer element consists of the polymer composition of the invention as defined above or in claims including the preferable subgroups and embodiments thereof, in any order. In case of a multilayer front and/or back encapsulation layer element, then independently, the at least one layer which comprises, preferably consists of, the polymer composition of the invention is preferably (an) outer layer(s) of the multilayer structure.

More preferably, at least one, preferably both, of the front and back encapsulation layer element is/are an encapsulation monolayer element.

The rigid protective front layer element and the rigid protective back layer element can be a rigid monolayer element or rigid multilayer element. The rigid monolayer elment is preferably a glass layer element. The rigid multilayer element can be e.g. a glass layer element covered from either one or both sides by a polymeric layer(s), like protective polymeric layer(s).

The rigid protective front layer element and the rigid protective back layer element preferably consist of a glass monolayer element or a multilayer element comprising a glass layer, preferably a glass monolayer element.

The type and thickness of the glass layer element for front and/or rear protective layer element can vary, independently, depending on the desired PV module solution. Typically the type and thickness of the front and/or back glass layer element is as conventionally used in the PV field.

The "photovoltaic element" means that the element has photovoltaic activity. The photovoltaic element can be e.g. an element of photovoltaic cell(s), which has a well known meaning in the art. Silicon based material, e.g. crystalline silicon, is a non-limiting example of materials used in photovoltaic cell(s). Crystalline silicon material can vary with respect to crystallinity and crystal size, as well known to a skilled person. Alternatively, the photovoltaic element can be a substrate layer on one surface of which a further layer or deposit with photovoltaic activity is subjected, for example a glass layer, wherein on one side thereof an ink material with photovoltaic activity is printed, or a substrate layer on one side thereof a material with photovoltaic activity is deposited. For instance, in well-known thin film solutions of photovoltaic elements e.g. an ink with photovoltaic activity is printed on one side of a substrate, which is typically a glass substrate.

The photovoltaic element is most preferably an element of photovoltaic cell(s).

"Photovoltaic cell(s)" means herein a layer element(s) of photovoltaic cells, as explained above, together with connectors.

The PV module may comprise other layer elements as well, as known in the field of PV modules. Moreover, any of the other layer elements can be mono or multilayer elements.

In some embodiments there can be an adhesive layer between the the different layer layer elements and/or between the layers of a multilayer element, as well known in the art. Such adhesive layers has the function to improve the adhesion between the two elements and have a well known meaning in the lamination field. The adhesive layers are differentiated from the other functional layer elements of the PV module, e.g. those as specified above, below or in claims, as evident for a skilled person in the art.

As well knonw in the PV field, the thickness of the above mentioned elements, as well as any additional elements, of the laminated photovoltaic module of the invention can vary depending on the desired photovoltaic module embodiment and can be chosen accordingly by a person skilled in the PV field.

All the above elements of the photovoltaic module have a well known meaning. The protective front layer element, preferably a front glass layer element, a front encapsulation layer element, a photovoltaic element, a rear encapsulation layer element and the protective front layer element, i.e. backsheet layer element, preferably a back glass layer element, can be produced in a manner well known in the photovoltaic field or are commercially available.

The polymer composition of at least one of the front or rear encapsulation layer element can be commercially available or be produced as defined above under "Polymer (a), silane group(s) containing units (b) and the polymer composition".

As said the thickness of the different layer elements of PV module can vary depending on the type of the PV module and the material of the layer elements, as well known for a skilled person.

As a non-limiting example only, the thickness of the front and/or back, preferably of the front and back, encapsulation monolayer or multilayer element, preferably of front and/or back, preferably of the front and back, encapsulation monolayer is typically up to 2 mm, preferably up to 1 mm, typically 0.3 to 0.6 mm.

As a non-limiting example only, the thickness of the rigid protective front layer element, e.g. glass layer, is typically up to 10 mm, preferably up to 8 mm, preferably 2 to 4 mm.

As a non-limiting example only, the thickness of the rigid protective back (backsheet) layer element, e.g. glass layer, is typically up to 10 mm, preferably up to 8 mm, preferably 2 to 4 mm.

As a non-limiting example only, the thickness of a photovoltaic element, e.g. an element of monocrystalline photovoltaic cell(s), is typically between 100 to 500 microns.

It is also to be understood that part of the elements can be in integrated form, i.e. two or more of said PV elements can be integrated together, preferably by lamination, before the elements of the assembly step (i) are introduced to said step (i).

The photovoltaic module of the invention can be produced in a manner well known in the field of the photovoltaic modules. The polymeric layer elements can be produced for example by extrusion, preferably by co- or cast film extrusion, in a conventional manner using the conventional extruder and film formation equipment. The layers of any multilayer element(s) and/or any adjacent layer(s) between two layer elements can e.g. be partly or fully be coextruded or laminated.

The different elements of the photovoltaic module are typically assembled together by conventional means to produce the final photovoltaic module. Elements can be provided to such assembly step separately or e.g. two elements can fully or partly be in integrated form, as well known in the art. The different element parts can then be attached together by lamination using the conventional lamination techniques in the field. The assembling of photovoltaic module is well known in the field of photovoltaic modules.

Said front and/or rear encapsulation monolayer element comprising, preferably consisting of, the polymer composition of the invention is preferably extruded or laminated, preferably laminated, to adjacent layer elements or coextruded with a layer(s) of an adjacent layer element.

**Lamination process of the PV module**

As said, the above elements of the PV module are typically premade before the assembling thereof to a form of PV module assembly. Such elements can be produced using conventional processes. Typically the front and/or rear encapsulation layer element comprising the polymer composition of the invention is produced by cast extrusion (e.g. in case of a polymeric monolayer element) or by coextrusion (e.g. in case of a polymeric multilayer element). The coextrusion can be carried out by cast extrusion or by blown film extrusion which both are very well known processes in the film production filed and with the skills of a skilled person.

The following process conditions of the lamination process are more preferable for producing the photovoltaic module of the invention, and can be combined in any order.

The preferred process for producing the PV module of the invention is a lamination process, wherein the different functional layer elements, typically premade layer elements, of the PV module are laminated to form the integrated final PV module.

The invention thus also provides a lamination process for producing a photovoltaic module comprising, in the given order, a rigid protective front layer element, a front encapsulation layer element, a photovoltaic element, a rear encapsulation layer element and a rigid protective back layer element, wherein at least one of the front encapsulation layer element and rear encapsulation element comprises a polymer composition comprising

- a polymer of ethylene (a) selected from:

  (a2) a polymer of ethylene containing one or more polar comonomer(s) selected from (C1-C6)-alkyl acrylate comonomer(s), and optionally bears functional group(s) containing units other than said polar comonomer; or
  (a3) a polymer of ethylene containing one or more alpha-olefin comonomer selected from (C1-C10)-alpha-olefin comonomer; and optionally bears functional group(s) containing units; and

- silane group(s) containing units (b);
  and wherein the polymer (a) has a melt flow rate, $MFR_2$, of less than 20 g/10 min (according to ISO 1133 at 190 °C and at a load of 2.16 kg);
  wherein the process comprises the steps of:

  (i) assembling step to arrange the rigid protective front layer element, the front encapsulation layer element, the photovoltaic element, the rear encapsulation layer element and the rigid protective back layer element, in given order, to form of a photovoltaic module assembly;
  (ii) heating step to heat up the photovoltaic module assembly optionally in a chamber at evacuating conditions;
  (iii) pressing step to build and keep pressure on the photovoltaic module assembly at the heated conditions for the lamination of the assembly to occur; and
  (iv) recovering step to cool and remove the obtained photovoltaic module for later use.

The lamination process is carried out in a laminator equipment which can be e.g. any conventional laminator which is suitable for the multilaminate to be laminated. The choice of the laminator is within the skills of a skilled person. Typically the laminator comprises a chamber wherein the heating, optional, and preferable, evacuation, pressing and recovering (including cooling) steps (ii)-(iv) take place.

In a preferable lamination process of the invention:

- the pressing step (iii) is started when at least one of the front encapsulation or rear encapsulation layer element(s) reaches a temperature which is at least 3 to 10°C higher than the melting temperature of the polymer of ethylene (a) present in said front and/or encapsulation layer element; and
- the total duration of the pressing step (iii) is up to 15 minutes.

The duration of the heating step (ii) is preferably up to 10 minutes, preferably 3 to 7 minutes. The heating step (ii) can be and is typically done step-wise.

Pressing step (iii) is preferably started when the at least one polymeric layer element reaches a temperature which is 3 to 10°C higher than the melting temperature of the polymer (a), preferably of the polymer (a1) or (a2), of said polymeric layer element.

The pressing step (iii) is preferably started when the at least one polymeric layer element reaches a temperature of at least of 85 °C, suitably to 85 to 150, suitably to 85 to 148, suitably 85 to 140, preferably 90 to 130, preferably 90 to 120, preferably 90 to 115, preferably 90 to 110, preferably 90 to 108,°C.

At the pressing step (iii), the duration of the pressure build up is preferably up to 5, preferably 0.5 to 3 minutes. The pressure built up to the desired level during pressing step can be done either in one step or can be done in multiple steps.

At the pressing step (iii), the duration of holding the pressure is preferably up to 10, preferably 3.0 to 10, minutes.

The total duration of the pressing step (iii) is preferably from 2 to 10 minutes.

The total duration of the heating step (ii) and pressing step (iii) is preferably up to 25, preferably from 2 to 20, minutes.

The pressure used in the pressing step (iii) is preferably up to 1000 mbar, preferably 500 to 900 mbar.

### Determination methods

Unless otherwise stated in the description or in the experimental part, the following methods were used for the property determinations of the polymer composition, polar polymer and/or any sample preparations thereof as specified in the text or expereimental part.

### Melt Flow Rate

The melt flow rate (MFR) is determined according to ISO 1133 and is indicated in g/10 min. The MFR is an indication of the flowability, and hence the processability, of the polymer. The higher the melt flow rate, the lower the viscosity of the polymer. The MFR is determined at 190 °C for polyethylene. MFR may be determined at different loadings such as 2.16 kg ($MFR_2$) or 5 kg ($MFR_5$).

### Density

Low density polyethylene (LDPE): The density of the polymer was measured according to ISO 1183-2. The sample preparation was executed according to ISO 1872-2 Table 3 Q (compression moulding).

### Comonomer contents:

**The content (wt% and mol%) of polar comonomer present in the polymer and the content (wt% and mol%) of silane group(s) containing units (preferably comonomer) present in the polymer composition (preferably in the polymer):**

Quantitative nuclear-magnetic resonance (NMR) spectroscopy was used to quantify the comonomer content of the polymer composition or polymer as given above or below in the context.

Quantitative $^1$H NMR spectra recorded in the solution-state using a Bruker Advance III 400 NMR spectrometer operating at 400.15 MHz. All spectra were recorded using a standard broad-band inverse 5 mm probehead at 100°C using nitrogen gas for all pneumatics. Approximately 200 mg of material was dissolved in *1,2*-tetrachloroethane-$d_2$ (TCE-$d_2$) using ditertiarybutylhydroxytoluen (BHT) (CAS 128-37-0) as stabiliser. Standard single-pulse excitation was employed utilising a 30 degree pulse, a relaxation delay of 3 s and no sample rotation. A total of 16 transients were acquired per spectra using 2 dummy scans. A total of 32k data points were collected per FID with a dwell time of 60 $\mu$s, which corresponded to to a spectral window of approx. 20 ppm. The FID was then zero filled to 64k data points and an exponential window function applied with 0.3 Hz line-broadening. This setup was chosen primarily for the ability to resolve the quantitative signals resulting from methylacrylate and vinyltrimethylsiloxane copolymerisation when present in the same polymer.

Quantitative $^1$H NMR spectra were processed, integrated and quantitative properties determined using custom spectral analysis automation programs. All chemical shifts were internally referenced to the residual protonated solvent signal at 5.95 ppm.

When present characteristic signals resulting from the incorporation of vinylacytate (VA), methyl acrylate (MA), butyl acrylate (BA) and vinyltrimethylsiloxane (VTMS), in various comonomer sequences, were observed (Rande1189). All comonomer contents calculated with respect to all other monomers present in the polymer.

The vinylacytate (VA) incorporation was quantified using the integral of the signal at 4.84 ppm assigned to the *VA sites, accounting for the number of reporting nuclie per comonomer and correcting for the overlap of the OH protons from BHT when present:

$$VA = (\ I_{*VA} - (I_{ArBHT})/2)\ /\ 1$$

The methylacrylate (MA) incorporation was quantified using the integral of the signal at 3.65 ppm assigned to the 1MA sites, accounting for the number of reporting nuclie per comonomer:

$$MA = I_{1MA}\ /\ 3$$

The butylacrylate (BA) incorporation was quantified using the integral of the signal at 4.08 ppm assigned to the 4BA sites, accounting for the number of reporting nuclie per comonomer:

$$BA = I_{4BA}\ /\ 2$$

The vinyltrimethylsiloxane incorporation was quantified using the integral of the signal at 3.56 ppm assigned to the 1VTMS sites, accounting for the number of reporting nuclei per comonomer:

$$VTMS = I_{1VTMS}\ /\ 9$$

Characteristic signals resulting from the additional use of BHT as stabiliser, were observed. The BHT content was quantified using the integral of the signal at 6.93 ppm assigned to the ArBHT sites, accounting for the number of reporting nuclei per molecule:

$$BHT = I_{ArBHT}\ /\ 2$$

The ethylene comonomer content was quantified using the integral of the bulk aliphatic (bulk) signal between 0.00 - 3.00 ppm. This integral may include the 1VA (3) and $\alpha$VA (2) sites from isolated vinylacetate incorporation, *MA and $\alpha$MA sites from isolated methylacrylate incorporation, 1BA (3), 2BA (2), 3BA (2), *BA (1) and $\alpha$BA (2) sites from isolated butylacrylate incorporation, the *VTMS and $\alpha$VTMS sites from isolated vinylsilane incorporation and the aliphatic sites from BHT as well as the sites from polyethylene sequences. The total ethylene comonomer content was calculated based on the bulk integral and compensating for the observed comonomer sequences and BHT:

$$E = (1/4)*[\ I_{bulk} - 5*VA - 3*MA - 10*BA - 3*VTMS - 21*BHT\ ]$$

It should be noted that half of the $\alpha$ signals in the bulk signal represent ethylene and not comonomer and that an insignificant error is introduced due to the inability to compensate for the two saturated chain ends (S) without associated branch sites.
The total mole fractions of a given monomer (M) in the polymer was calculated as:

$$fM = M\ /\ (\ E + VA + MA + BA + VTMS\ )$$

The total comonomer incorporation of a given monomer (M) in mole percent was calculated from the mole fractions in the standard manner:

$$M\ [mol\%] = 100\ *\ fM$$

The total comonomer incorporation of a given monomer (M) in weight percent was calculated from the mole fractions and molecular weight of the monomer (MW) in the standard manner:

$$M\ [wt\%] = 100\ *\ (\ fM\ *\ MW)\ /\ (\ (fVA\ *\ 86.09) + (fMA\ *\ 86.09) + (fBA\ *\ 128.17) + (fVTMS\ *\ 148.23) + ((1\text{-}fVA\text{-}fMA\text{-}fBA\text{-}fVTMS)\ *\ 28.05)\ )$$

randall89: J. Randall, Macromol. Sci., Rev. Macromol. Chem. Phys. 1989, C29, 201.

If characteristic signals from other specific chemical species are observed the logic of quantification and/or compensation can be extended in a similar manor to that used for the specifically described chemical species. That is, identification of characteristic signals, quantification by integration of a specific signal or signals, scaling for the number of reported nuclei and compensation in the bulk integral and related calculations. Although this process is specific to the specific chemical species in question the approach is based on the basic principles of quantitative NMR spectroscopy of polymers and thus can be implemented by a person skilled in the art as needed.

**Adhesion test:**

The adhesion test is performed on laminated strips, the encaplulant film and backsheet is peeled of in a tensile tesing equipment while measuring the force required for this.

A laminate consisting of glass, 2 encapsulant films and backsheet is first laminated. Between the glass and the first encapsulat film a small sheet of Teflon is inserted at one of the ends, this will generate a small part of the encapsulants and backsheet that is not adhered to the glass. This part will be used as the anchoring point for the tensile testing device.

The laminate is then cut along the laminate to form a 15 mm wide strip, the cut goes through the backsheet and the encapsulant films all the way down to the glass surface.

The laminate is mounted in the tensile testing equipment and the clamp of the tensile testing device is attached to the end of the strip.

The pulling angle is 90 ° in relation to the laminate and the pulling speed is 14 mm/min.

The pulling force is measured as the average during 50 mm of peeling starting 25 mm into the strip. The average force over the 50 mm is divided by the width of the strip (15 mm) and presented as adhesion strength (N/cm).

**Rheological properties:**

**Dynamic Shear Measurements (frequency sweep measurements)**

The characterisation of melt of polymer composition or polymer as given above or below in the context by dynamic shear measurements complies with ISO standards 6721-1 and 6721-10. The measurements were performed on an Anton Paar MCR501 stress controlled rotational rheometer, equipped with a 25 mm parallel plate geometry. Measurements were undertaken on compression moulded plates, using nitrogen atmosphere and setting a strain within the linear viscoelastic regime.

The oscillatory shear tests were done at 190 °C applying a frequency range between 0.01 and 600 rad/s and setting a gap of 1.3 mm.

In a dynamic shear experiment the probe is subjected to a homogeneous deformation at a sinusoidal varying shear strain or shear stress (strain and stress controlled mode, respectively). On a controlled strain experiment, the probe is subjected to a sinusoidal strain that can be expressed by

$$\gamma(t) = \gamma_0 \sin(\omega t) \qquad (1)$$

If the applied strain is within the linear viscoelastic regime, the resulting sinusoidal stress response can be given by

$$\sigma(t) = \sigma_0 \sin(\omega t + \delta) \qquad (2)$$

where

$\sigma_0$ and $\gamma_0$ are the stress and strain amplitudes, respectively
$\omega$ is the angular frequency
$\delta$ is the phase shift (loss angle between applied strain and stress response)
t is the time

Dynamic test results are typically expressed by means of several different rheological functions, namely the shear storage modulus G', the shear loss modulus, G", the complex shear modulus, G", the complex shear viscosity, $\eta^*$, the dynamic shear viscosity, $\eta'$, the out-of-phase component of the complex shear viscosity $\eta''$ and the loss tangent, tan δ which can be expressed as follows:

$$G' = \frac{\sigma_0}{\gamma_0} \cos\delta \ [\text{Pa}] \qquad\qquad (3)$$

$$G'' = \frac{\sigma_0}{\gamma_0} \sin\delta \ [\text{Pa}] \qquad\qquad (4)$$

$$G^* = G' + iG'' \ [\text{Pa}] \qquad\qquad (5)$$

$$\eta^* = \eta' - i\eta'' \ [\text{Pa.s}] \qquad\qquad (6)$$

$$\eta' = \frac{G''}{\omega} \ [\text{Pa.s}] \qquad\qquad (7)$$

$$\eta'' = \frac{G'}{\omega} \ [\text{Pa.s}] \qquad\qquad (8)$$

Besides the above mentioned rheological functions one can also determine other rheological parameters such as the so-called elasticity index *El(x)*. The elasticity index *El(x)* is the value of the storage modulus, G' determined for a value of the loss modulus, G" of x kPa and can be described by equation (9).

$$El(x) = G' \ for \ (G'' = x \ kPa) \ [\text{Pa}] \qquad\qquad (9)$$

For example, the El(5kPa) is the defined by the value of the storage modulus G', determined for a value of G" equal to 5 kPa.
Shear Thinning Index ($SHI_{0.05/300}$) is defined as a ratio of two viscosities measured at frequencies 0.05 rad/s and 300 rad/s, $\mu_{0.05}/\mu_{300}$.

References:

[1] Rheological characterization of polyethylene fractions" Heino, E.L., Lehtinen, A., Tanner J., Seppälä, J., Neste Oy, Porvoo, Finland, Theor. Appl. Rheol., Proc. Int. Congr. Rheol, 11th (1992), 1, 360-362
[2] The influence of molecular structure on some rheological properties of polyethylene", Heino, E.L., Borealis Polymers Oy, Porvoo, Finland, Annual Transactions of the Nordic Rheology Society, 1995.).
[3] Definition of terms relating to the non-ultimate mechanical properties of polymers, Pure & Appl. Chem., Vol. 70, No. 3, pp. 701-754, 1998.

**Melting temperature, crystallization temperature ($T_{cr}$), and degree of crystallinity**

The melting temperature Tm of the used polymers was measured in accordance with
ASTM D3418. Tm and Tcr were measured with Mettler TA820 differential scanning calorimetry (DSC) on 3+-0.5 mg samples. Both crystallization and melting curves were obtained during 10 °C/min cooling and heating scans between -10 to 200 °C. Melting and crystallization temperatures were taken as the peaks of endotherms and exotherms. The degree of crystallinity was calculated by comparison with heat of fusion of a perfectly crystalline polymer of the same polymer type, e.g. for polyethylene, 290 J/g.

**Experimental part**

**Preparation of inventive polymer examples (Copolymer of ethylene with methyl acrylate comonomer and with vinyl trimethoxysilane comonomer)**

Polymerisation of the polymer (a) of inventive inventive layer element, Inv. Ex.1-Inv.Ex4: Inventive polymer (a) was produced in a commercial high pressure tubular reactor at a pressure 2500-3000 bar and max temperature 250-300 °C using conventional peroxide initiatior. Ethylene monomer, methyl acrylate (MA) polar comonomer and vinyl trimethoxy silane (VTMS) comonomer silane group(s) containing comonomer (b)) were added to the reactor system in a conventional manner. CTA was used to regulate MFR as well known for a skilled person. After having the information of the property balance desired for the inventive final polymer (a), the skilled person can control the process to obtain the inventive polymer (a).

The amount of the vinyl trimethoxy silane units, VTMS, (=silane group(s) containing units), the amount of MA and $MFR_2$ are given in the table 1.

The properties in below tables were measured from the polymer (a) as obtained from the reactor or from a layer sample as indicated below.

Table 1: Product properties of Inventive Examples

| Test polymer | Inv.Ex.1 | Inv.Ex 2 | Inv.Ex 3 | Inv. Ex 4 |
|---|---|---|---|---|
| Properties of the polymer obtained from the reactor | | | | |
| $MFR_{2,16}$, g/10 min | 2.0 | 4.5 | 1.0 | 8.0 |
| acrylate content, mol% (wt%) | MA 8.1 (21) | MA 8.6 (22) | MA 8.0 mol% | MA 9.8 mol% |
| Melt Temperature, °C | 92 | 90 | 92 | 86 |
| VTMS content, mol% (wt%) | 0.41 (1.8) | 0.38 (1.7) | 0.47 | 0.28 |
| Density, kg/m$^3$ | 948 | 946 | 947 | 951 |
| SHI (0.05/300), 150°C | 70 | 52 | | |

In above table 1 and below MA denotes the content of Methyl Acrylate comonomer present in the polymer and, respectively, VTMS content denotes the content of vinyl trimethoxy silane comonomer present in the polymer.

**Comparative polymer example:**

**Comp.polymer 30:** Copolymer of ethylene with methyl acrylate comonomer and with vinyl trimethoxysilane comonomer, produced in HP with same principles as above: $MFR_2$ of 30 g/10 min, MA content of 12.4 mol%, VTMS of 0.48 mol%, density of 960 kg/m$^3$, Tm 81°C.

**Test of flowing-out of the polymer of the encapsulant element:**

**Test module elements:**

Protective front layer element: Glass layer, i.e.Solatex solar glass, supplied by AGC, length: 300 mm and width: 300 mm, total thickness of 3,0 mm

Front and rear encapsulant element: each consisted of inventive polymer 1, 2, 3, 4 or comparative polymer, respectively, as given in table 2, each sample had same width and length dimensions as the protective front and back layer element and each independently had the total thickness of 0.45 mm Protective back layer element: Glass layer, i.e.Solatex solar glass, supplied by AGC, length: 300 mm and width: 300 mm, total thickness of 3,0 mm

**Lamination procedure for each inventive and comparative test laminate:** the protective solar glass was used with above given dimensions 300mm x 300mm and thickness 3,0 mm. The encapsultant element (film) was cut with the same dimensions as the solar glass. Two pieces of encapsultant element (film) each with a thickness of 0,45mm were put between two solar glasses to have a total thickness of the laminate of 6,9 mm.

Lamination was carried out in laminator temperature setting at 150°C: The duration of heating step under vacuum (ii) was 5 minutes and total duration of pressing step (iii) was 10 minutes at 800 mbar pressure using a fully automated PV modules laminator P. Energy L036LAB. After this lamination process the test laminate was taken out from the laminator and cooled down to room temperature in the open air. Afterwards the thickness was measured as described below from the middle of each 4 sides of the each formed test laminate and from the 4 corners of each test laminate. The change from each of middle and corner measurement in the table 2 is an average of the 4 middle/corner measurements of the side of the respective laminate.

Table 2: Test results

| Test module | MFR | Total thickness of the laminate after lamination | Change* (mm) (%) | Change** (mm) (%) |
|---|---|---|---|---|
| Inv. module 3 | 1 | 6,52 | 0,38 mm (42%) | 0,17 mm (18%) |
| Inv. module 1 | 2.0 | 6,45 | 0,45 mm (50%) | 0,25 mm (27%) |
| Inv. module 4 | 8.0 | 6,35 | 0,55 mm (61%) | 0,30 mm (33%) |
| Comp.module | 30 | 6,29 | 0,61 mm (69%) | 0,32 mm (36%) |
| *Change in encap thickness layer measured at the corners of the glass module
**Change in encap thickness layer measured at the middle on the side of the glass module | | | | |

### PV module example:

### PV module elements:

Protective front layer element: Glass layer, i.e.Solatex solar glass, supplied by AGC, length: 1632 mm and width: 986 mm, total thickness of 3,2 mm
Front and rear encapsulant element: inventive polymer example 1, with same width and length dimensions as the protective front and back layer element, each had the total thickness of 0.45 mm PV cell element: 60 monocrystalline solar cells, cell dimension156*156 mm from Tsec Taiwan, 2 buss bars, total thickness of 200 micron.
Protective back layer element: Glass layer, i.e.Solatex solar glass, supplied by AGC, length: 1632 mm and width: 986 mm, total thickness of 3,2 mm

### Preparation of PV module (60 cells solar module) assembly for the lamination:

Two PV module assembly were prepared as follows. The front protective glass element (Solatex AGC) was cleaned with isopropanol before putting the first encapsultant film on the solar glass. The solar glass element has the following dimensions: 1632 mm x 986 x 3,2 mm (b*1*d). The front encapsulant element was cut in the same dimension as the solar glass element. The solar cells as PV cell element have been automatically stringed by 10 cells in series with a distance between the cells of 1,5 mm. After the front encapsulant element was put on the front protective glass element, then the solar cells were put on the front encapsulant element with 6 rows of each 10 cells with a distance between the rows of ± 2,5 mm to have a total of 60 cells in the solar module as a standard module. Then the ends of the solar cells are soldered together to have a fully integrated connection as well known by the PV module producers. Further the rear encapsulant element was put on the obtained PV cell element and the back protective glass element (Solatex AGC) was cleaned with isopropanol before it was put on said the rear encapsulant element. The obtained PV module assembly was then subjected to a lamination process as described below.

### Lamination process of the 60 cells solar modules:

**Laminator:** ICOLAM 25/15, supplied by Meier Vakuumtechnik GmbH.
Each PV module assembly sample was laminated in a Meier ICOLAM 25/15 laminator from Meier Vakuumtechnik GmbH with a laminator temperature setting of 170°C and pressure setting of 800 mbar. The duration of the lamination steps are given in table 3.

Table 3: Lamination process with duration of the steps of the process

| Lamination Test no. | Heating step (ii) with Evacuation (min) | Encapsulant temperature when pressing starts (°C) | Pressure build up substep of pressing step (iii) (min) | Holding the pressure substep of pressing step (iii) (min) | Total time of steps (ii) + (iiia) and (iiib) of (iii) (min) |
|---|---|---|---|---|---|
| Test 1 | 7.0 | 100 | 3.0 | 10.0 | 20.0 |

The PV module produced using the above conditions had no sign of cell breakage, bubble formation or air holes. The electroluminescence (EL) study of each of the modules show no cell cracks. The PV modules strong adhesive strength between glass and encapsulant.

**Claims**

1. A photovoltaic module comprising, in the given order, a rigid protective front layer element, a front encapsulation layer element, a photovoltaic element, a rear encapsulation layer element and a rigid protective back layer element, wherein at least one of the front encapsulation layer element or rear encapsulation element comprises a polymer composition comprising

   - a polymer of ethylene (a) selected from:

      (a2) a polymer of ethylene containing one or more polar comonomer(s) selected from (Cl-C6)-alkyl acrylate comonomer(s), and optionally bears functional group(s) containing units other than said polar comonomer; or
      (a3) a polymer of ethylene containing one or more alpha-olefin comonomer selected from (C1-C10)-alpha-olefin comonomer; and optionally bears functional group(s) containing units;

   whereby the comonomer(s) of polymer (a), if present, is/are other than vinyl acetate comonomer; and
   - silane group(s) containing units (b);
   and wherein the polymer (a) has a melt flow rate, $MFR_2$, of less than 20 g/10 min (according to ISO 1133 at 190 °C and at a load of 2.16 kg), and
   wherein the polymer composition of at least one of the front or rear encapsulation layer element is not subjected to any silanol condensation catalyst (SCC), which is selected from the group of carboxylates of tin, zinc, iron, lead or cobalt or aromatic organic sulphonic acids, before or during the production process of the photovoltaic module.

2. The photovoltaic module according to claim 1, wherein the polymer composition has an $MFR_2$ of 0.1 to 15 g/10 min, when measured according to ISO 1133 at 190 °C and at a load of 2.16 kg.

3. The photovoltaic module according to any of the preceding claims, wherein a Shear Thinning Index, $SHI_{0.05/300}$, of 30.0 to 100.0, preferably of of 40.0 to 80.0, when measured according to "Rheological properties: Dynamic Shear Measurements (frequency sweep measurements)" as described in the specification under "Determination Methods".

4. The photovoltaic module according to any of the preceding claims, wherein the polymer of ethylene (a) has a melting temperature, Tm, of less than 100°C, when as described in the specification under "Determination Methods".

5. The photovoltaic module according to any of the preceding claims, wherein the polymer composition comprises

   - polymer (a) which is selected from
   (a2) a polymer of ethylene containing one or more polar comonomer(s) selected from (Cl-C6)-alkyl acrylate comonomer(s), and optionally bears functional group(s) containing units other than said polar comonomer; and
   - silane group(s) containing units (b).

6. The photovoltaic module according to any of the preceding claims, wherein the polymer composition more comprises

   - polymer (a) which is selected from (a2) a polymer of ethylene containing one or more polar comonomer(s) selected from (Cl-C6)-alkyl acrylate rylate comonomer(s), and optionally bears functional group(s) containing units other than said polar comonomer; and
   - silane group(s) containing units (b);
   more preferably wherein , the polymer composition comprises
   - a polymer (a) which is the polymer of ethylene (a2) containing one or more polar comonomer(s) selected from (Cl-C6)-alkyl acrylate preferably one (C1-C6)-alkyl acrylate, and bears functional group(s) containing units other than said polar comonomer; and
   - silane group(s) containing units (b): more preferably a polymer of ethylene (a2) containing one (C1-C4)-alkyl acrylate, more preferably a polymer of ethylene (a2) containing methyl acrylate comonomer, and bears the silane group(s) containing units (b) as the functional group(s) containing units.

7. The photovoltaic module according to any of the preceding claims, wherein the silane group(s) containing unit (b) is a hydrolysable unsaturated silane compound represented by the formula (I):

R1SiR2qY3-q (I)
wherein
R1 is an ethylenically unsaturated hydrocarbyl, hydrocarbyloxy or (meth)acryloxy hydrocarbyl group,
each R2 is independently an aliphatic saturated hydrocarbyl group,
Y which may be the same or different, is a hydrolysable organic group and
q is 0, 1 or 2, the amount of the silane group(s) containing units (b) present in the layer, preferably in the polymer (a), is from 0.01 to 1.00 mol %, when determined according to "Comonomer contents" as described in the specification under "Determination Methods"; which compound of formula (I) is preferably copolymerized or grafted to the polymer (a) as said optional functional group(s) containing units.

8. The photovoltaic module according to any of the preceding claims, wherein polymer (a) is a copolymer of ethylene (al) with vinyl trimethoxysilane comonomer or a copolymer of ethylene (a2) with methylacrylate comonomer and with vinyl trimethoxysilane comonomer.

9. The photovoltaic module according to any of the preceding claims, wherein no crosslinking agent selected from peroxide is introduced to the polymer (a) of the polymer composition.

10. The photovoltaic module according to any of the preceding claims, wherein both the front encapsulation element and the rear encapsulation element comprise the polyethylene composition.

11. The photovoltaic module according to any of the preceding claims, wherein the front encapsulation element is a monolayer element or a multilayer element comprising at least one layer, which comprises the polyethylene composition, suitably the front encapsulation element is a front encapsulation monolayer element.

12. The photovoltaic module s according to any of the preceding claims, wherein rear encapsulation element is a monolayer element or a multilayer element comprising at least one layer, which comprises the polyethylene composition, suitably the rear encapsulation element is a rear encapsulation monolayer element.

13. The photovoltaic module according to any of the preceding claims, wherein the rigid front cover element is a glass layer.

14. The photovoltaic module according to any of the preceding claims, wherein the rigid back cover element is a glass layer.

15. The photovoltaic module according to any of the preceding claims, which is a dual glass photovoltaic module comprising, in a given order, a front glass layer element, a front encapsulation, at least one photovoltaic element, a rear encapsulation element and a back glass layer element.

16. A use of the polymer composition as defined in any of the preceding claims for producing a layer of a dual glass photovoltaic module as defined in any of the preceding claims.

17. A lamination process for producing a photovoltaic module according to any of the preceding claims 1-154 comprising, in the given order, a rigid protective front layer element, a front encapsulation layer element, a photovoltaic element, a rear encapsulation layer element and a rigid protective back layer element, wherein at least one of the front encapsulation layer element and rear encapsulation element comprises a polymer composition comprising

- a polymer of ethylene (a) selected from:

(a2) a polymer of ethylene containing one or more polar comonomer(s) selected from (Cl-C6)-alkyl acrylate comonomer(s), and optionally bears functional group(s) containing units other than said polar comonomer; or
(a3) a polymer of ethylene containing one or more alpha-olefin comonomer selected from (C1-C10)-alpha-olefin comonomer; and optionally bears functional group(s) containing units;

whereby the comonomer(s) of polymer (a), if present, is/are other than vinyl acetate comonomer; and
- silane group(s) containing units (b);

and wherein the polymer (a) has a melt flow rate, $MFR_2$, of less than 20 g/10 min (according to ISO 1133 at 190 °C and at a load of 2.16 kg), and

wherein the polymer composition of at least one of the front or rear encapsulation layer element is not subjected to any silanol condensation catalyst (SCC), which is selected from the group of carboxylates of tin, zinc, iron, lead or cobalt or aromatic organic sulphonic acids, before or during the production process of the photovoltaic module;

wherein the process comprises the steps of:

(i) assembling step to arrange the rigid protective front layer element, the front encapsulation layer element, the photovoltaic element, the rear encapsulation layer element and the rigid protective back layer element, in given order, to form of a photovoltaic module assembly;

(ii) heating step to heat up the photovoltaic module assembly optionally in a chamber at evacuating conditions;

(iii) pressing step to build and keep pressure on the photovoltaic module assembly at the heated conditions for the lamination of the assembly to occur; and

(iv) recovering step to cool and remove the obtained photovoltaic module for later use.

**Patentansprüche**

1. Photovoltaikmodul, umfassend in der gegebenen Reihenfolge ein starres Schutzvorderschichtelement, ein vorderes Einkapselungsschichtelement, ein photovoltaisches Element, ein hinteres Einkapselungsschichtelement und ein starres Schutzrückschichtelement, wobei mindestens eines von dem vorderen Einkapselungsschichtelement oder dem hinteren Einkapselungselement eine Polymer-Zusammensetzung umfasst, die umfasst

- ein Polymer von Ethylen (a), ausgewählt aus:

(a2) einem Polymer von Ethylen, das ein oder mehrere polare(s) Comonomer(e) enthält, ausgewählt aus (C1-C6)-Alkylacrylat-Comonomer(en), und gegebenenfalls funktionelle Gruppe(n) enthaltende Einheiten, die von dem polaren Comonomer verschieden sind, trägt; oder

(a3) einem Polymer von Ethylen, das ein oder mehrere Alpha-Olefin-Comonomere enthält, ausgewählt aus (C1-C10)-Alpha-Olefin-Comonomer(en); und gegebenenfalls funktionelle Gruppe(n) enthaltende Einheiten trägt;

wobei das (die) Comonomer(e) des Polymers (a), falls vorliegend, ein anderes als Vinylacetat-Comonomer ist (sind); und

- Silangruppe(n) enthaltende Einheiten (b);

und wobei das Polymer (a) eine Schmelzfließrate $MFR_2$ von weniger als 20 g/10 min (gemäß ISO 1133 bei 190°C und bei einer Last von 2,16 kg) aufweist, und

wobei die Polymer-Zusammensetzung von mindestens einem der vorderen oder hinteren Einkapselungsschichtelemente vor oder während des Herstellungsverfahrens des Photovoltaikmoduls keinem Silanolkondensationskatalysator (SCC), der aus der Gruppe der Carboxylate von Zinn, Zink, Eisen, Blei oder Kobalt oder aromatischen organischen Sulfonsäuren ausgewählt ist, unterworfen wird.

2. Photovoltaikmodul nach Anspruch 1, wobei die Polymer-Zusammensetzung eine $MFR_2$ von 0,1 bis 15 g/10 min aufweist, wenn sie gemäß ISO 1133 bei 190°C und bei einer Last von 2,16 kg gemessen wird.

3. Photovoltaikmodul nach einem der vorangehenden Ansprüche, wobei ein Strukturviskositätsindex $SHI_{0,05/300}$ von 30,0 bis 100,0, vorzugsweise von 40,0 bis 80,0, gemessen gemäß "Rheologische Eigenschaften: Dynamische Schermessungen (Frequenz-Sweep-Messungen) ", wie in der Beschreibung unter "Bestimmungsverfahren" beschrieben, vorliegt.

4. Photovoltaikmodul nach einem der vorangehenden Ansprüche, wobei das Polymer von Ethylen (a) eine Schmelztemperatur Tm von weniger als 100°C hat, wenn es wie in der Beschreibung unter "Bestimmungsverfahren" beschrieben, ist.

5. Photovoltaikmodul nach einem der vorangehenden Ansprüche, wobei die Polymer-Zusammensetzung umfasst

- Polymer (a), das ausgewählt ist aus (a2) einem Polymer von Ethylen, das ein oder mehrere polare(s) Comonomer(e) enthält, ausgewählt aus (C1-C6)-Alkylacrylat-Comonomer(en), und gegebenenfalls funktionelle Gruppe(n) enthaltende Einheiten, die von dem polaren Comonomer verschieden sind, trägt; und
- Silangruppe(n) enthaltende Einheiten (b).

6. Photovoltaikmodul nach einem der vorangehenden Ansprüche, wobei die Polymer-Zusammensetzung weiter umfasst

- Polymer (a), das ausgewählt ist aus (a2) einem Polymer von Ethylen, das ein oder mehrere polare (s) Comonomer(e) enthält, ausgewählt aus (C1-C6)-Alkylacrylat-Comonomer(en), und gegebenenfalls funktionelle Gruppe(n) enthaltende Einheiten, die von dem polaren Comonomer verschieden sind, trägt; und
- Silangruppe(n) enthaltende Einheiten (b);
bevorzugter, wobei die Polymer-Zusammensetzung umfasst
- ein Polymer (a), das das Polymer von Ethylen (a2) ist, das ein oder mehrere polare (s) Comonomer(e) enthält, ausgewählt aus (C1-C6)-Alkylacrylat, vorzugsweise einem (C1-C6)-Alkylacrylat, und funktionelle Gruppe(n) enthaltende Einheiten, die von dem polaren Comonomer verschieden sind, trägt; und
- Silangruppe(n) enthaltende Einheiten (b); bevorzugter
- ein Polymer von Ethylen (a2), das ein (C1-C4)-Alkylacrylat enthält, bevorzugter ein Polymer von Ethylen (a2), das Methylacrylat-Comonomer enthält, und das die Silangruppe(n) enthaltende Einheiten (b) als die funktionelle(n) Gruppe(n) enthaltenden Einheiten, trägt.

7. Photovoltaikmodul nach einem der vorangehenden Ansprüche, wobei die Silangruppe(n) enthaltende Einheit (b) eine hydrolysierbare ungesättigte Silanverbindung ist, die durch die Formel (I) dargestellt wird:

$$R1SiR2qY3-q \qquad (I)$$

worin

R1 eine ethylenisch ungesättigte Kohlenwasserstoff-, Kohlenwasserstoffoxy- oder (Meth)acryloxy-Kohlenwasserstoffgruppe ist,
jedes R2 unabhängig eine aliphatische gesättigte Kohlenwasserstoffgruppe ist,
Y, das gleich oder verschieden sein kann, eine hydrolysierbare organische Gruppe ist und
q 0, 1 oder 2 ist, die Menge der Silangruppe(n) enthaltenden Einheiten (b), die in der Schicht, vorzugsweise im Polymer (a), vorhanden ist, 0,01 bis 1,00 Mol-% beträgt, wenn sie gemäß dem "Comonomergehalt", wie in der Beschreibung unter "Bestimmungsverfahren" beschrieben, bestimmt wird; wobei die Verbindung der Formel (I) vorzugsweise als die wahlweise(n) funktionelle(n) Gruppe(n) enthaltenen Einheiten auf das Polymer (a) copolymerisiert oder gepfropft ist.

8. Photovoltaikmodul nach einem der vorangehenden Ansprüche, wobei das Polymer (a) ein Copolymer von Ethylen (al) mit Vinyltrimethoxysilan-Comonomer oder ein Copolymer von Ethylen (a2) mit Methylacrylat-Comonomer und mit Vinyltrimethoxysilan-Comonomer ist.

9. Photovoltaikmodul nach einem der vorangehenden Ansprüche, wobei kein Vernetzungsmittel, ausgewählt aus Peroxid, in das Polymer (a) der Polymer-Zusammensetzung eingeführt worden ist.

10. Photovoltaikmodul nach einem der vorangehenden Ansprüche, wobei sowohl das vordere Einkapselungselement als auch das hintere Einkapselungselement die Polyethylen-Zusammensetzung umfassen.

11. Photovoltaikmodul nach einem der vorangehenden Ansprüche, wobei das vordere Einkapselungselement ein Monoschichtelement oder ein Mehrschichtelement ist, das mindestens eine Schicht umfasst, die die Polyethylen-Zusammensetzung umfasst, wobei das vordere Einkapselungselement in geeigneter Weise ein vorderes Einkapselungs-Monoschichtelement ist.

12. Photovoltaikmodul nach einem der vorangehenden Ansprüche, wobei das hintere Einkapselungselement ein Monoschichtelement oder ein Mehrschichtelement ist, das mindestens eine Schicht umfasst, die die Polyethylen-Zusammensetzung umfasst, wobei das hintere Einkapselungselement in geeigneter Weise ein hinteres Einkapselungs-Monoschichtelement ist.

**13.** Photovoltaikmodul nach einem der vorangehenden Ansprüche, wobei das starre vordere Abdeckelement eine Glasschicht ist.

**14.** Photovoltaikmodul nach einem der vorangehenden Ansprüche, wobei das starre hintere Abdeckelement eine Glasschicht ist.

**15.** Photovoltaikmodul nach einem der vorangehenden Ansprüche, das ein photovoltaisches Doppelglasmodul ist, das in einer gegebenen Reihenfolge ein vorderes Glasschichtelement, eine vordere Einkapselung, mindestens ein photovoltaisches Element, ein hinteres Einkapselungselement und ein hinteres Glasschichtelement umfasst.

**16.** Verwendung der Polymer-Zusammensetzung, wie in einem der vorangehenden Ansprüche definiert, zur Herstellung einer Schicht eines photovoltaischen Doppelglasmoduls, wie in einem der vorangehenden Ansprüche definiert.

**17.** Laminierungsverfahren zur Herstellung eines Photovoltaikmoduls nach einem der vorhergehenden Ansprüche 1-15, umfassend in der gegebenen Reihenfolge ein starres Schutzvorderschichtelement, ein vorderes Einkapselungsschichtelement, ein photovoltaisches Element, ein hinteres Einkapselungsschichtelement und ein starres Schutzrückschichtelement, wobei mindestens eines von dem vorderen Einkapselungsschichtelement oder dem hinteren Einkapselungselement eine Polymer-Zusammensetzung umfasst, die umfasst

- ein Polymer von Ethylen (a), ausgewählt aus:

(a2) einem Polymer von Ethylen, das ein oder mehrere polare(s) Comonomer(e) enthält, ausgewählt aus (C1-C6)-Alkylacrylat-Comonomer(en), und gegebenenfalls funktionelle Gruppe(n) enthaltende Einheiten, die von dem polaren Comonomer verschieden sind, trägt; oder
(a3) ein Polymer aus Ethylen, das ein oder mehrere Alpha-Olefin-Comonomere enthält, ausgewählt aus (C1-C10)-Alpha-Olefin-Comonomeren; und gegebenenfalls funktionelle Gruppe(n) enthaltende Einheiten trägt;

wobei das (die) Comonomer(e) des Polymers (a), falls vorliegend, ein anderes als Vinylacetat-Comonomer ist (sind); und
- Silangruppe(n) enthaltende Einheiten (b);
und wobei das Polymer (a) eine Schmelzfließrate $MFR_2$ von weniger als 20 g/10 min (gemäß ISO 1133 bei 190°C und bei einer Last von 2,16 kg) aufweist, und
wobei die Polymer-Zusammensetzung von mindestens einem der vorderen oder hinteren Einkapselungsschichtelemente vor oder während des Herstellungsverfahrens des Photovoltaikmoduls keinem Silanolkondensationskatalysator (SCC), der aus der Gruppe der Carboxylate von Zinn, Zink, Eisen, Blei oder Kobalt oder aromatischen organischen Sulfonsäuren ausgewählt ist, unterworfen wird;
wobei das Verfahren die Schritte umfasst:

(i) Zusammenbauschritt, um das starre Schutzvorderschichtelement, das vordere Einkapselungsschichtelement, das photovoltaische Element, das hintere Einkapselungsschichtelement und das starre Schutzrückschichtelement in einer gegebenen Reihenfolge anzuordnen, um eine Photovoltaikmodulbaugruppe zu bilden;
(ii) Erwärmungsschritt zum Aufheizen der Photovoltaikmodulbaugruppe gegebenenfalls in einer Kammer unter Evakuierungsbedingungen;
(iii) Pressschritt zum Aufbau und Halten des Drucks auf die Photovoltaikmodulbaugruppe bei den erwärmten Bedingungen, damit die Laminierung der Baugruppe erfolgt; und
(iv) Rückgewinnungsschritt zur Kühlung und Entfernung des erhaltenen Photovoltaikmoduls für die spätere Verwendung.

**Revendications**

**1.** Module photovoltaïque comprenant, dans l'ordre indiqué, un élément de couche avant de protection rigide, un élément de couche d'encapsulation avant, un élément photovoltaïque, un élément de couche d'encapsulation arrière et un élément de couche d'envers de protection rigide, dans lequel au moins l'un parmi l'élément de couche d'encapsulation avant et l'élément d'encapsulation arrière comprend une composition de polymère comprenant

- un polymère d'éthylène (a) choisi parmi :

(a2) un polymère d'éthylène contenant un ou plusieurs comonomères polaires choisis parmi les comonomères d'acrylate d'alkyle en $C_1$ à $C_6$, et optionnellement qui porte des motifs contenant un ou plusieurs groupes fonctionnels autres que ledit comonomère polaire ; et

(a3) un polymère d'éthylène contenant un ou plusieurs comonomères d'alpha-oléfine choisis parmi les comonomères d'alpha-oléfine en $C_1$ à $C_{10}$; et optionnellement qui porte des motifs contenant un ou plusieurs groupes fonctionnels ;

moyennant quoi le ou les comonomères du polymère (a), s'ils sont présents, sont autres qu'un comonomère d'acétate de vinyle ; et

- des motifs contenant un ou plusieurs groupes silane (b) ;

et dans lequel le polymère (a) a un indice de fluage, $MFR_2$, inférieur à 20 g/10 min (conformément à la norme ISO 1133 à 190°C et sous une charge de 2,16 kg), et

dans lequel la composition de polymère d'au moins l'un des éléments de couche d'encapsulation avant et arrière n'est soumis à aucun catalyseur de condensation de silanol (SCC), qui est choisi dans le groupe des carboxylates d'étain, zinc, fer, plomb et cobalt et des acides sulfoniques organiques aromatiques, avant ou pendant le procédé de production du module photovoltaïque.

2. Module photovoltaïque selon la revendication 1, dans lequel la composition de polymère a un $MFR_2$ de 0,1 à 15 g/10 min, quand il est mesuré conformément à la norme ISO 1133 à 190°C et sous une charge de 2,16 kg.

3. Module photovoltaïque selon l'une quelconque des revendications précédentes, dans lequel l'indice de fluidification par cisaillement, $SHI_{0,05/300}$, est de 30,0 à 100,0, de préférence de 40,0 à 80,0, quand il est mesuré conformément à "Propriétés rhéologiques : mesures de cisaillement dynamique (mesures de balayage de fréquence)" comme décrit dans le fascicule sous la rubrique "Procédés de détermination".

4. Module photovoltaïque selon l'une quelconque des revendications précédentes, dans lequel le polymère d'éthylène (a) a un point de fusion, Tm, inférieur à 100°C, lorsqu'il est tel que décrit dans le fascicule sous la rubrique "Procédés de détermination".

5. Module photovoltaïque selon l'une quelconque des revendications précédentes, dans lequel la composition de polymère comprend

- un polymère (a) qui est choisi parmi
(a2) un polymère d'éthylène contenant un ou plusieurs comonomères polaires choisis parmi les comonomères d'acrylate d'alkyle en $C_1$ à $C_6$, et optionnellement qui porte des motifs contenant un ou plusieurs groupes fonctionnels autres que ledit comonomère polaire ; et
- des motifs contenant un ou plusieurs groupes silane (b) .

6. Module photovoltaïque selon l'une quelconque des revendications précédentes, dans lequel la composition de polymère comprend de plus

- un polymère (a) qui est choisi parmi
(a2) un polymère d'éthylène contenant un ou plusieurs comonomères polaires choisis parmi les comonomères d'acrylate d'alkyle en $C_1$ à $C_6$, et optionnellement qui porte des motifs contenant un ou plusieurs groupes fonctionnels autres que ledit comonomère polaire ; et
- des motifs contenant un ou plusieurs groupes silane (b) ;
plus préférablement dans lequel la composition de polymère comprend
- un polymère (a) qui est un polymère d'éthylène (a2) contenant un ou plusieurs comonomères polaires choisis parmi les acrylates d'alkyle en $C_1$ à $C_6$, de préférence un seul acrylate d'alkyle en $C_1$ à $C_6$, et qui porte des motifs contenant un ou plusieurs groupes fonctionnels autres que ledit comonomère polaire ; et
- des motifs contenant un ou plusieurs groupes silane (b) ;
plus préférablement
un polymère d'éthylène (a2) contenant un seul acrylate d'alkyle en $C_1$ à $C_4$, plus préférablement un polymère d'éthylène (a2) contenant un comonomère d'acrylate de méthyle, et qui porte des motifs contenant un ou plusieurs groupes silane en tant que motifs contenant un ou plusieurs groupes fonctionnels.

**7.** Module photovoltaïque selon l'une quelconque des revendications précédentes, dans lequel le motif contenant un ou plusieurs groupes silane (b) est un composé de silane insaturé hydrolysable représenté par la formule (I) :

R1SiR2qY3-q          (I)

dans laquelle

R1 est un groupe à insaturation éthylénique hydrocarbyle, hydrocarbyloxy ou (méth)acryloxyhydrocarbyle, chaque R2 est indépendamment un groupe hydrocarbyle saturé aliphatique,
Y, qui peut être identique ou différent, est un groupe organique hydrolysable, et
q est 0, 1 ou 2, la quantité des motifs contenant un ou plusieurs groupes silane (b) présents dans la couche, de préférence dans le polymère (a), est de 0,01 à 1,00 % en moles, quand elle est déterminée conformément à "Teneurs en comonomères" comme décrit dans le fascicule sous la rubrique "Procédés de détermination" ; lequel composé de formule (I) est de préférence copolymérisé ou greffé au polymère (a) à titre desdits motifs contenant un ou plusieurs groupes fonctionnels optionnels.

**8.** Module photovoltaïque selon l'une quelconque des revendications précédentes, dans lequel le polymère (a) est un copolymère d'éthylène (a1) avec un comonomère de vinyltriméthoxysilane ou un copolymère d'éthylène (a2) avec un comonomère d'acrylate de méthyle et avec un comonomère de vinyltriméthoxysilane.

**9.** Module photovoltaïque selon l'une quelconque des revendications précédentes, dans lequel aucun agent de réticulation choisi parmi les peroxydes n'est introduit dans le polymère (a) de la composition de polymère.

**10.** Module photovoltaïque selon l'une quelconque des revendications précédentes, dans lequel tant l'élément d'encapsulation avant que l'élément d'encapsulation arrière comprennent la composition de polyéthylène.

**11.** Module photovoltaïque selon l'une quelconque des revendications précédentes, dans lequel l'élément d'encapsulation avant est un élément monocouche ou un élément multicouche comprenant au moins une couche, qui comprend une composition de polyéthylène, convenablement l'élément d'encapsulation avant est un élément monocouche d'encapsulation avant.

**12.** Module photovoltaïque selon l'une quelconque des revendications précédentes, dans lequel l'élément d'encapsulation arrière est un élément monocouche ou un élément multicouche comprenant au moins une couche, qui comprend une composition de polyéthylène, convenablement l'élément d'encapsulation arrière est un élément monocouche d'encapsulation arrière.

**13.** Module photovoltaïque selon l'une quelconque des revendications précédentes, dans lequel l'élément de recouvrement avant rigide est une couche de verre.

**14.** Module photovoltaïque selon l'une quelconque des revendications précédentes, dans lequel l'élément de recouvrement arrière rigide est une couche de verre.

**15.** Module photovoltaïque selon l'une quelconque des revendications précédentes, qui est un module photovoltaïque en verre double comprenant, dans l'ordre indiqué, un élément de couche de verre avant, une encapsulation avant, au moins un élément photovoltaïque, un élément d'encapsulation arrière et un élément de couche de verre arrière.

**16.** Utilisation de la composition de polymère telle que définie dans l'une quelconque des revendications précédentes pour produire une couche d'un module photovoltaïque en verre double tel que défini dans l'une quelconque des revendications précédentes.

**17.** Procédé de stratification pour produire un module photovoltaïque selon l'une quelconque des revendications 1 à 15 comprenant, dans l'ordre indiqué, un élément de couche avant de protection rigide, un élément de couche d'encapsulation avant, un élément photovoltaïque, un élément de couche d'encapsulation arrière et un élément de couche d'envers de protection rigide, dans lequel au moins l'un parmi l'élément de couche d'encapsulation avant et l'élément d'encapsulation arrière comprend une composition de polymère comprenant

- un polymère d'éthylène (a) choisi parmi :

(a2) un polymère d'éthylène contenant un ou plusieurs comonomères polaires choisis parmi les comonomères d'acrylate d'alkyle en $C_1$ à $C_6$, et optionnellement qui porte des motifs contenant un ou plusieurs groupes fonctionnels autres que ledit comonomère polaire ; et

(a3) un polymère d'éthylène contenant un ou plusieurs comonomères d'alpha-oléfine choisis parmi les comonomères d'alpha-oléfine en $C_1$ à $C_{10}$; et optionnellement qui porte des motifs contenant un ou plusieurs groupes fonctionnels ;

moyennant quoi le ou les comonomères du polymère (a), s'ils sont présents, sont autres qu'un comonomère d'acétate de vinyle ; et

- des motifs contenant un ou plusieurs groupes silane (b) ;

et dans lequel le polymère (a) a un indice de fluage, $MFR_2$, inférieur à 20 g/10 min (conformément à la norme ISO 1133 à 190°C et sous une charge de 2,16 kg), et

dans lequel la composition de polymère d'au moins l'un des éléments de couche d'encapsulation avant et arrière n'est soumis à aucun catalyseur de condensation de silanol (SCC), qui est choisi dans le groupe des carboxylates d'étain, zinc, fer, plomb et cobalt et des acides sulfoniques organiques aromatiques, avant ou pendant le procédé de production du module photovoltaïque ;

dans lequel le procédé comprend les étapes suivantes :

(i) une étape d'assemblage pour agencer l'élément de couche avant de protection rigide, l'élément de couche d'encapsulation avant, l'élément photovoltaïque, l'élément de couche d'encapsulation arrière et l'élément de couche arrière de protection rigide, dans l'ordre indiqué, pour former un assemblage de module photovoltaïque ;

(ii) une étape de chauffage pour chauffer l'assemblage de module photovoltaïque optionnellement dans une chambre dans des conditions d'évacuation ;

(iii) une étape de pressage pour accumuler et maintenir une pression sur l'assemblage de module photovoltaïque dans les conditions chauffées pour qu'ait lieu la stratification de l'assemblage ; et

(iv) une étape de récupération pour refroidir et retirer le module photovoltaïque obtenu pour une utilisation ultérieure.

Fig.1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2892080 A
- EP 2144301 A
- EP 2579331 A
- WO 2011160964 A, Borealis
- EP 736065 A
- EP 1309631 A
- EP 1309632 A

**Non-patent literature cited in the description**

- **HANS ZWEIFEL.** Plastic Additives Handbook. 2001
- Encyclopedia of Polymer Science and Engineering. 1986, vol. 6, 383-410
- Polyethylene: High-pressure. **R.KLIMESCH ; D.LITTMANN ; F.-O. MÄHLING.** Encyclopedia of Materials: Science and Technology. Elsevier Science Ltd, 2001, 7181-7184
- **J. RANDALL.** *Macromol. Sci., Rev. Macromol. Chem. Phys.,* 1989, vol. C29, 201
- **HEINO, E.L. ; LEHTINEN, A. ; TANNER J. ; SEP-PÄLÄ, J. ; NESTE OY ; PORVOO, FINLAND.** Rheological characterization of polyethylene fractions. *Theor. Appl. Rheol., Proc. Int. Congr. Rheol,* 1992, vol. 1, 360-362
- **HEINO, E.L. ; BOREALIS POLYMERS OY ; POR-VOO, FINLAND.** The influence of molecular structure on some rheological properties of polyethylene. *Annual Transactions of the Nordic Rheology Society,* 1995
- Definition of terms relating to the non-ultimate mechanical properties of polymers. *Pure & Appl. Chem.,* 1998, vol. 70 (3), 701-754